# FASCICULE DE BREVET EUROPEEN

(11) **EP 3 843 123 B1**
(45) Date de publication et mention de la délivrance du brevet: **06.05.2026**
(21) Numéro de dépôt: 21151991.3
(22) Date de dépôt: 20.12.2017
(51) Int. Cl.: H01J 37/32, H01J 37/317, C23C 14/48, G04B 39/00

(54) **INSTALLATION D'IMPLANTATION D'IONS DANS LA SURFACE D'UN OBJET À TRAITER**
ANLAGE ZUR IMPLANTATION VON IONEN IN DIE OBERFLÄCHE EINES ZU BEHANDELNDEN OBJEKTS
INSTALLATION FOR IMPLANTING IONS INTO THE SURFACE OF AN OBJECT TO BE TREATED

(43) Date de publication de la demande: 30.06.2021
(62) Demande divisionnaire de: 17209168.8
(73) Titulaire: The Swatch Group Research and Development Ltd, 2074 Marin (CH)
(72) Inventeur: Miko, Csilla, 1417 Essertines-sur-Yverdon (CH); Vuille, Pierry, 2338 Les Emibois (CH); Bazin, Jean-Luc, 2512 Tüscherz-Alfermée (CH); Kool, Arne, 1807 Blonay (CH); Boulmay, Alexis, 25800 Valdahon (FR)
(74) Mandataire: ICB SA

(56) Documents cités:
- WO-A1-2016/062779
- CH-B1- 713 929
- JP-A- H0 714 761
- JP-A- H01 119 668
- US-A- 5 522 935
- US-A1- 2007 187 615
- US-A1- 2017 207 063

## Description

### Domaine technique de l'invention

La présente invention a pour objet une installation pour la mise en œuvre d'un procédé d'implantation ionique dans la surface d'un objet à traiter, notamment mais non exclusivement un objet en saphir synthétique, au moyen d'un faisceau d'ions. Cette installation vise à augmenter le nombre d'ions qu'il est possible d'implanter dans la surface de l'objet à traiter et la profondeur à laquelle ces ions peuvent pénétrer dans l'objet. Le procédé peut s'appliquer tout aussi bien à un objet massif qu'à un objet à l'état de poudre formé de particules métalliques ou de particules céramiques.

### Arrière-plan technologique de l'invention

Les procédés d'implantation ionique consistent à bombarder la surface de l'objet à traiter par exemple au moyen d'une source d'ions mono- ou multichargés du type à résonance cyclotron électronique. Une telle installation est encore connue sous sa dénomination anglo-saxonne Electron Cyclotron Resonance ou ECR.

Une source d'ions ECR fait usage de la résonance cyclotronique des électrons pour créer un plasma. Des micro-ondes sont injectées dans un volume de gaz à basse pression destiné à être ionisé, à une fréquence correspondant à la résonance cyclotron électronique définie par un champ magnétique appliqué à une région située à l'intérieur du volume de gaz à ioniser. Les micro-ondes chauffent les électrons libres présents dans le volume de gaz à ioniser. Ces électrons libres, sous l'effet de l'agitation thermique, vont entrer en collision avec les atomes ou les molécules et provoquent leur ionisation. Les ions produits correspondent au type de gaz utilisé. Ce gaz peut être pur ou composé. Il peut également s'agir d'une vapeur obtenue à partir d'un matériau solide ou liquide. La source d'ions ECR est en mesure de produire des ions simplement chargés, c'est-à-dire des ions dont le degré d'ionisation est égal à 1, ou bien des ions multichargés, c'est-à-dire des ions dont le degré d'ionisation est supérieur à 1.

A titre d'exemple, une source d'ions multichargés du type à résonance cyclotron électronique ECR est illustrée sur la figure 1 annexée à la présente demande de brevet. Très schématiquement, une source d'ions multichargés ECR, désignée dans son ensemble par la référence numérique générale 1, comprend un étage d'injection 2 dans lequel on introduit un volume 4 de gaz à ioniser et une onde hyperfréquence 6, un étage de confinement magnétique 8 dans lequel est créé un plasma 10, et un étage d'extraction 12 qui permet d'extraire et d'accélérer les ions du plasma 10 au moyen d'une anode 14a et d'une cathode 14b entre lesquelles est appliquée une haute tension.

L'aspect du faisceau d'ions 16 produit en sortie de la source d'ions ECR 1 est illustré à la figure 2 annexée à la présente demande de brevet.

L'un des problèmes rencontré avec le procédé d'implantation ionique brièvement décrit ci-dessus réside dans le fait qu'au fur et à mesure que les ions pénètrent dans la surface de l'objet à traiter, ils créent une barrière de potentiel électrostatique qui tend à ralentir les ions qui arrivent subséquemment, ce qui limite la profondeur de pénétration de ces ions sous la surface de l'objet à traiter. En effet, plus les ions sont nombreux à être implantés à la surface de l'objet à traiter, plus le champ électrostatique que créent ces ions est élevé, et plus la surface de l'objet à traiter tend à repousser les ions qui arrivent de la source d'ions ECR, ce qui pose des problèmes d'homogénéité dans le procédé d'implantation ionique de l'objet à traiter. Dans le cas où l'objet à traiter est conducteur de l'électricité, ce problème est moins présent dans la mesure où certains au moins des électrons libres ou faiblement liés du matériau dans lequel est réalisé l'objet à traiter peuvent se recombiner avec les ions implantés. Par contre, dans le cas où l'objet à traiter est réalisé en un matériau non conducteur de l'électricité, le phénomène de recombinaison entre électrons et ions mono- ou multichargés ne se produit pas, et garantir une distribution homogène des ions dans la surface de l'objet à traiter est pratiquement impossible.

Les documents JPH01 119668 A et US 2017/0207063 A1 comptent sur l'apparition, dans la surface de l'objet à traiter, d'un courant électrique induit par le rayonnement ultraviolet au moyen duquel cette surface est éclairée, pour évacuer les charges en excès qui se sont accumulées dans l'objet à traiter.

Le document WO2016/06779 décrit par ailleurs un procédé d'implantation d'ions et des substrats en verre à ions implantés.

Le document US2007/187615 décrit un système de contrôle de charge comprenant un plateau dont la surface est configurée pour recevoir une plaquette, et un moniteur de charge disposés par rapport au plateau de manière à ce qu'un faisceau d'ions frappe simultanément une partie du moniteur de charge et une partie de la plaquette.

Le document US5522935 décrit un dispositif pour le dépôt chimique en phase vapeur assisté par plasma pour la fabrication d'un dispositif semiconducteur.

Le document JP07014761 décrit un appareil apte à neutraliser les corps chargés tels que les substrats traités pour les dispositifs à semiconducteurs.

### Résumé de l'invention

La présente invention a pour but de résoudre les problèmes mentionnés ci-dessus ainsi que d'autres encore en procurant une installation pour la mise en œuvre d'un procédé d'implantation d'ions à la surface d'un objet à traiter permettant notamment de garantir une répartition homogène de ces ions sur la surface de l'objet.

A cet effet, la présente invention concerne une installation pour la mise en œuvre d'un procédé d'implantation d'ions sur une surface d'un objet à traiter selon la revendication 1 annexée à la présente demande de brevet.

Grâce à ces caractéristiques, la présente invention procure une installation pour la mise en œuvre d'un procédé de traitement de surface d'un objet dans laquelle l'objet à traiter, placé dans une chambre à vide, est éclairé au moyen d'une source de lumière ultraviolette en même temps que cet objet est bombardé au moyen d'un faisceau d'ions. Cette installation permet ainsi de garantir une répartition plus homogène des ions à la surface de l'objet à traiter, de même qu'elle permet à ces ions de pénétrer plus profondément sous la surface de l'objet à traiter. On comprend en effet que, malgré le vide assez poussé qui règne dans la chambre à vide, il subsiste néanmoins dans l'atmosphère de la chambre à vide des atomes et des molécules auxquels les photons du rayonnement ultraviolet vont arracher des électrons qui vont être attirés par le potentiel positif de la surface de l'objet à traiter et vont se recombiner avec les ions présents à la surface de cet objet de façon à annuler les charges électrostatiques. Fruit de la recombinaison entre les électrons libres qui se trouvent dans la chambre à vide et les ions implantés à la surface de l'objet à traiter, le potentiel électrostatique de l'objet à traiter peut être maintenu à des valeurs suffisamment faibles pour gêner le moins possible l'implantation de nouveaux ions et leur permettre de pénétrer suffisamment profondément sous la surface de l'objet à traiter.

Selon une forme de réalisation de l'invention, la pression atmosphérique à l'intérieur de la chambre à vide est comprise entre 10⁴ et 10⁻⁴ Pa, et de préférence entre 10⁻² Pa et 10⁻⁴ Pa.

Selon une forme de réalisation de l'invention, on injecte un gaz tel qu'un gaz noble dans la chambre à vide. En effet, en raison du vide assez poussé qui règne dans la chambre à vide dans laquelle est placé l'objet à traiter, on a constaté que les atomes et molécules qui subsistent dans cette atmosphère raréfiée ne sont pas toujours en nombre suffisant pour garantir une mise en œuvre satisfaisante du procédé d'implantation d'ions. C'est pourquoi, à titre de variante, il est prévu d'enrichir l'atmosphère de la chambre à vide avec un gaz noble afin que le phénomène d'ionisation de cette atmosphère produise des électrons en quantités plus importantes.

### Brève description des figures

D'autres caractéristiques et avantages de la présente invention ressortiront plus clairement de la description détaillée qui suit d'un exemple de réalisation de l'installation d'implantion d'ions, cet exemple étant donné à titre purement illustratif et non limitatif seulement en liaison avec le dessin annexé sur lequel :

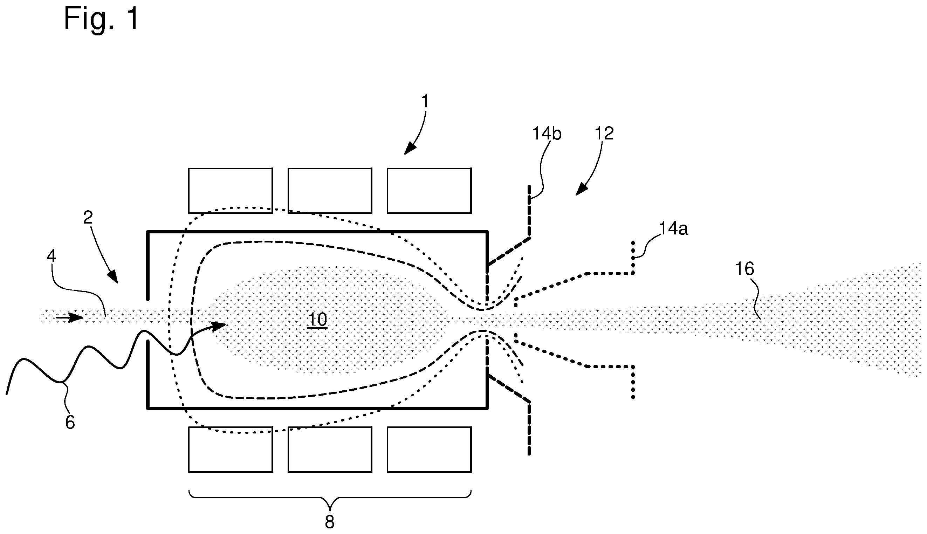

- la figure 1, déjà citée, est une vue schématique d'une source d'ions du type à résonance cyclotron électronique ECR selon l'art antérieur ;
- la figure 2, déjà citée, est une vue schématique qui illustre un faisceau d'ions à la sortie de la source d'ions du type à résonance cyclotron électronique ECR illustrée à la figure 1 ;
- la figure 3 est une vue schématique d'une installation d'implantation d'ions mono- ou multichargés à la surface d'un objet à traiter selon l'invention, et
- la figure 4 est une vue à plus grande échelle de la zone entourée d'un cercle sur la figure 3 qui illustre le phénomène de recombinaison des électrons libres qui se trouvent dans l'atmosphère de la chambre à vide avec les ions présents à la surface de l'objet à traiter.

### Description détaillée d'un mode de réalisation de l'invention

La présente invention procède de l'idée générale inventive qui consiste à placer un objet soumis à un processus d'implantation ionique dans une chambre à vide et à l'éclairer au moyen d'un rayonnement ultraviolet en même temps qu'on le bombarde avec un faisceau d'ions mono- ou multichargés. En se propageant dans la chambre à vide, les photons du rayonnement ultraviolet arrachent des électrons aux atomes et aux molécules qui subsistent dans l'atmosphère raréfiée de la chambre à vide, ces électrons libres venant ensuite se recombiner avec les ions présents à la surface de l'objet dont on traite la surface. Il est ainsi possible de contrôler le potentiel de surface de l'objet à traiter et de maintenir ce potentiel à un niveau suffisamment bas pour que les nouveaux ions qui arrivent ne soient pas exagérément freinés par la barrière de potentiel et conservent une énergie cinétique suffisante leur permettant de pénétrer en profondeur dans l'objet à traiter.

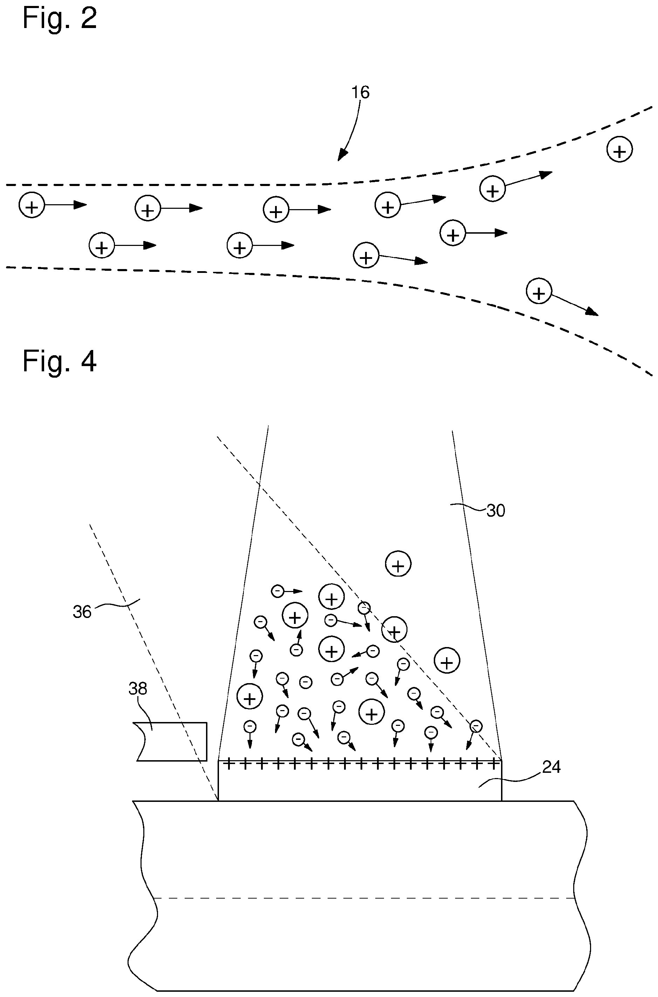

Une installation d'implantation ionique selon l'invention permettant la mise en œuvre du procédé est représentée schématiquement à la figure 3. Désignée dans son ensemble par la référence numérique générale 18, cette installation d'implantation ionique comprend une chambre à vide 20 dans l'enceinte étanche 22 de laquelle est placé un objet 24 destiné à être soumis à un procédé d'implantation ionique. L'objet 24 à traiter peut être massif ou bien se présenter à l'état de poudre. Il peut s'agir d'un matériau amorphe ou cristallin, isolant ou conducteur de l'électricité, métallique ou céramique. Dans le cas où l'objet 24 à traiter est à l'état de poudre, celle-ci sera préférentiellement agitée durant toute la durée du processus d'implantation ionique afin de s'assurer que les particules qui composent cette poudre soient exposées de manière homogène au faisceau d'implantation ionique.

Une source d'ions 26, par exemple du type à résonance cyclotron électronique ECR, est fixée de manière étanche sur l'enceinte 22 de la chambre à vide 20, en regard d'une première ouverture 28 ménagée dans cette enceinte 22. Cette source d'ions 26, d'un genre analogue à celui de la source d'ions ECR décrite ci-avant, est orientée de façon que le faisceau d'ions 30 mono- ou multichargés qu'elle produit se propage dans la chambre à vide 20 et vienne frapper la surface de l'objet 24 à traiter. Les ions mono- ou multichargés qui viennent frapper l'objet à traiter 24 pénètrent plus ou moins profondément sous la surface de cet objet 24 et s'accumulent progressivement, donnant ainsi naissance à une barrière de potentiel électrostatique qui tend à freiner et à repousser les ions qui arrivent par la suite, ce qui pose des problèmes d'inhomogénéité de la distribution des ions sur et sous la surface et dans l'épaisseur de l'objet 24 à traiter.

Pour remédier à ce problème, une source de rayonnement ultraviolet 32 est elle aussi montée de manière étanche sur l'enceinte 22 de la chambre à vide 20, face à une seconde ouverture 34 ménagée dans l'enceinte 22. Cette source de rayonnement ultraviolet 32 est orientée de façon que le rayonnement ultraviolet 36 qu'elle produit se propage dans la chambre à vide 20 et tombe sur la surface de l'objet à traiter 24 en même temps que le faisceau d'ions 30 frappe la surface de ce même objet à traiter 24.

Le vide qui règne dans l'enceinte étanche 22 de la chambre à vide 20 est relativement poussé, typiquement compris entre 10⁴ et 10⁻⁴ Pa, et de préférence entre 10⁻² Pa et 10⁻⁴ Pa. Néanmoins, malgré le vide assez poussé qui règne dans la chambre à vide 20, il subsiste dans l'atmosphère de cette chambre à vide 20 des atomes et des molécules auxquels les photons du rayonnement ultraviolet 36 vont arracher des électrons qui vont être attirés par le potentiel positif de la surface de l'objet à traiter 24 et vont se recombiner avec les ions présents à la surface de cet objet 24, de façon à annuler les charges électrostatiques. Le potentiel électrostatique de l'objet à traiter 24 peut ainsi être maintenu à des valeurs suffisamment faibles pour gêner le moins possible l'implantation de nouveaux ions et leur permettre de pénétrer suffisamment profondément sous la surface de l'objet à traiter 24.

Pour améliorer le processus d'implantation d'ions dans l'objet à traiter 24, il peut être envisagé d'enrichir l'atmosphère de la chambre à vide 20. Pour cela, la chambre à vide 20 est munie d'une valve d'admission 38 sur laquelle est raccordée une source de gaz 40, par exemple un gaz noble tel que de l'argon ou du xénon. Cette valve d'admission 38 débouche à proximité de l'objet à traiter 24, de manière à créer localement, au voisinage de l'objet à traiter 24, une légère surpression de gaz noble plus riche en atomes.

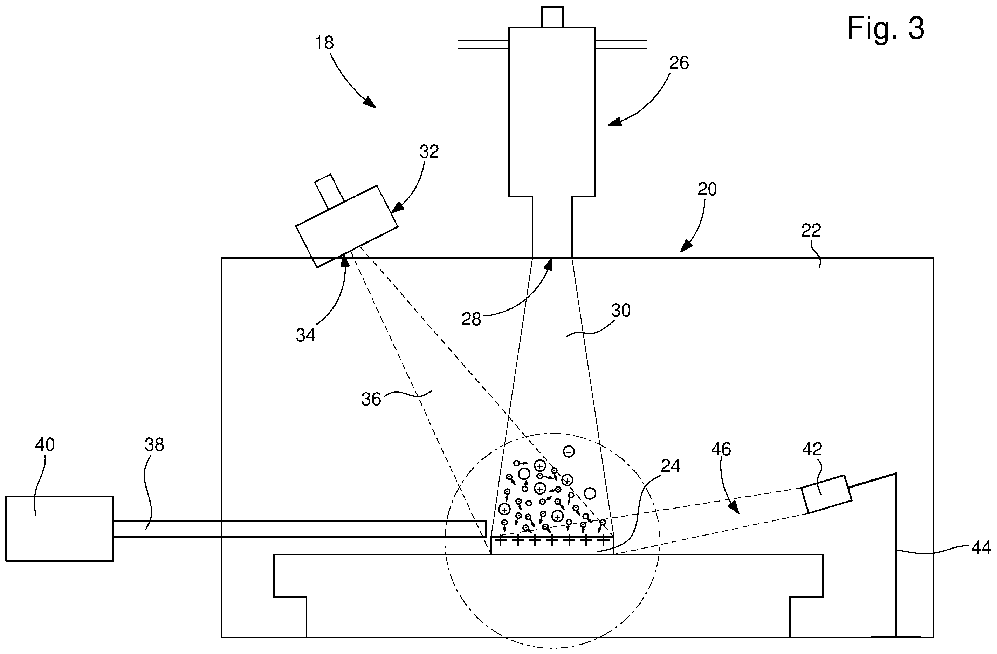

En procédant de la sorte, on enrichit l'atmosphère de la chambre à vide 20 et on augmente le nombre d'électrons arrachés aux atomes présents dans l'atmosphère qui règne dans la chambre à vide 20 (voir figure 4). Le processus de recombinaison entre les électrons dans la chambre à vide 20 et les ions à la surface de l'objet à traiter 24 est donc amplifié, ce qui permet d'abaisser encore davantage le potentiel électrique de l'objet à traiter. En effet, on s'est rendu compte avec une certaine surprise que les électrons arrachés par les photons du rayonnement ultraviolet aux atomes de gaz noble, bien qu'ils se recombinent pour partie avec des atomes ionisés du gaz noble, voire avec les ions du faisceau d'implantation ionique, se recombinent tout de même en nombre suffisamment grand avec les charges positives présentes à la surface de l'objet à traiter pour abaisser de manière sensible le potentiel électrostatique de la surface de l'objet à traiter.

Pour améliorer plus encore le processus d'implantation d'ions dans l'objet à traiter 24, une seconde source de rayonnement ultraviolet 42 est utilisée dans l'installation d'implantation ionique selon l'invention. Cette seconde source de rayonnement ultraviolet 42 peut être fixée de manière étanche sur l'enceinte 22 de la chambre à vide 20, ou bien être directement installée à l'intérieur de la chambre à vide 20 en étant supportée par un pied 44. La seconde source de rayonnement ultraviolet 42 est orientée de façon que le rayonnement ultraviolet 46 qu'elle émet forme un angle d'environ 90° par rapport au rayonnement ultraviolet 36 émis par la première source de rayonnement ultraviolet 32. Avec un tel agencement des sources de rayonnement ultraviolet 32, 42, il est possible de traiter des objets 24 de plus grandes dimensions.

Il va de soi que la présente invention n'est pas limitée aux modes de réalisation qui viennent d'être décrits et que diverses modifications et variantes simples peuvent être envisagées par l'homme du métier sans sortir du cadre de l'invention tel que défini par les revendications annexées.

On notera en particulier que la présente invention s'applique notamment au traitement de surface d'objets en saphir (naturel ou synthétique) pour la production de verres de montres. Grâce à l'installation d'implantation ionique selon l'invention, on diminue significativement la quantité de lumière incidente réfléchie par de tels verres, ce qui améliore significativement la lisibilité des informations affichées par les organes indicateurs (aiguilles, quantième, décors) situés sous ces verres.

La présente invention s'applique également au traitement de surface d'objets métalliques cristallins ou amorphes ou de céramiques dont les propriétés mécaniques, notamment la résistance aux rayures, sont grandement améliorées lorsqu'on leur applique le procédé d'implantation ionique avec neutralisation de charges.

La présente invention s'applique aussi au traitement de surface de particules d'un matériau métallique ou céramique à l'état de poudre. Les particules de poudre métallique ou céramique obtenues grâce à l'installation d'implantation ionique selon l'invention sont destinées à la fabrication de pièces massives grâce à des procédés de métallurgie des poudres tels que le procédé de moulage par injection, mieux connu sous sa dénomination anglo-saxonne Metal Injection Moulding ou MIM, le pressage ou bien encore la fabrication additive comme l'impression laser tridimensionnelle.

Selon des formes particulières de d'exécution de l'installation d'implantation ionique selon l'invention :
- la source d'ions mono- ou multichargés est du type à résonance cyclotron électronique ECR ;
- les ions sont accélérés sous une tension comprise entre 7'500 volts et 40'000 volts ;
- le matériau à partir duquel le faisceau d'ions est produit est choisi parmi l'azote N, le carbone C, l'oxygène O, l'argon Ar, l'hélium He et le néon Ne ;
- la dose d'ions implantés est comprise entre 1*10¹⁴ ions.cm⁻² et 7.5.10¹⁷ ions.cm⁻², et de préférence entre 1*10¹⁶ ions.cm⁻² et 15*10¹⁶ ions.cm⁻² ;
- la profondeur d'implantation des ions est de 150 nm à 250 nm ;
- le matériau métallique est un métal précieux choisi parmi l'or et le platine ;
- le matériau métallique est un métal non précieux choisi parmi le magnésium, le titane et l'aluminium ;
- on agite les particules de la poudre métallique ou céramique durant toute la durée du processus d'implantation ionique ;
- la granulométrie des particules de la poudre métallique ou céramique utilisée est telle que sensiblement 50% de l'ensemble de ces particules a une dimension inférieure à 2 micromètres, la dimension des particules de la poudre métallique ou céramique utilisée n'excédant pas 60 micromètres ;
- le matériau céramique traité au moyen de l'installation d'implantation ionique conforme à la présente invention est un carbure, en particulier un carbure de titane TiC ou un carbure de silicium SiC ;
- le matériau céramique de type carbure est bombardé au moyen d'ions azote N pour former un carbonitrure, notamment du carbonitrure de titane TiCN ou bien du carbonitrure de silicium SiCN ;
- le matériau céramique traité au moyen de l'installation d'implantation ionique selon l'invention est un nitrure, en particulier un nitrure de silicium Si₃N₄ ;
- le matériau céramique traité au moyen de l'installation d'implantation ionique conforme à la présente invention est un oxyde, notamment de la zircone ZrO₂ ou de l'alumine Al₂O₃ ;
- le matériau céramique de type oxyde est bombardé au moyen d'ions azote pour former un oxynitrure, notamment de l'oxynitrure de zircone ZrO(NO₃)₂, voire du nitrure de zirconium ZrN si l'on prolonge le bombardement ionique suffisamment longtemps, ou bien encore du nitrure d'alumine AlOₓN_{y} ;
- le matériau céramique de type oxyde est bombardé au moyen d'ions carbone pour former un carbonitrure, notamment du carbure de zircone ZrO₂C, voire du carbure de zirconium ZrC ;
- le matériau céramique de type oxyde est bombardé au moyen d'ions bore pour former un oxyborure, notamment du borure de zircone ZrO₂ B, voire du borure de zircone ZrB₂ si l'on prolonge le bombardement ionique suffisamment longtemps. L'invention est définie par les revendications.

### Nomenclature

1. Source d'ions multichargés du type à résonance cyclotron électronique ECR
2. Etage d'injection
4. Volume de gaz à ioniser
6. Onde hyperfréquence
8. Etage de confinement magnétique
10. Plasma
12. Etage d'extraction
14a. Anode
14b. Cathode
16. Faisceau d'ions mono- ou multichargés
18. Installation d'implantation ionique
20. Chambre à vide
22. Enceinte étanche
24. Objet à traiter
26. Source d'ions
28. Première ouverture
30. Faisceau d'ions mono- ou multichargés
32. Source de rayonnement ultraviolet
34. Seconde ouverture
36. Rayonnement ultraviolet
38. Valve d'admission
40. Source de gaz
42. Seconde source de rayonnement ultraviolet
44. Pied
46. Rayonnement ultraviolet

## Revendications

1. Installation d'implantation d'ions mono- ou multichargés dans une surface d'un objet à traiter (24), cette installation (28) comprenant une chambre à vide (20) dans laquelle est disposé l'objet à traiter (24), l'installation (18) comprenant également une source d'ions (26) apte à injecter dans la chambre à vide (20) un faisceau d'ions mono- ou multichargés (30), ce faisceau d'ions (30) étant dirigé vers la surface de l'objet à traiter (24), ladite source d'ions étant agencée pour que, lorsque l'installation est en service, les ions mono-ou multichargés frappent l'objet à traiter (24) et pénètrent plus ou moins profondément dans la surface de cet objet à traiter (24) et s'accumulent progressivement, donnant ainsi naissance à une barrière de potentiel électrostatique qui tend à freiner et à repousser les ions qui arrivent par la suite, l'installation (18) comprenant aussi une première source de rayonnement ultraviolet (32) agencée pour fonctionner en même temps que la source d'ions (26) et pour produire un premier rayonnement ultraviolet (36), ladite première source de rayonnement ultraviolet étant orientée de façon que, lorsque l'installation est en service, le premier rayonnement ultraviolet (36) se propage dans la chambre à vide (20) et tombe sur la surface de l'objet à traiter (24) en même temps que le faisceau d'ions (30) frappe la surface de ce même objet à traiter (24) afin que les photons du premier rayonnement ultraviolet (36) arrachent aux atomes et aux molécules présents dans la chambre à vide (20) des électrons qui vont être attirés par le potentiel positif de la surface de l'objet à traiter (24) et vont se recombiner avec les ions présents à la surface de l'objet à traiter (24), de façon à annuler les charges électrostatiques, ladite installation comprenant en outre une seconde source de rayonnement ultraviolet (42) agencée pour éclairer la surface de l'objet à traiter (24) avec un second rayonnement ultraviolet (46), ladite seconde source de rayonnement ultraviolet étant orientée de façon que, lorsque l'installation est en service, le second rayonnement ultraviolet (36) se propage dans la chambre à vide (20) selon une direction formant un angle d'environ 90° avec le premier rayonnement ultraviolet (36).

2. Installation d'implantation d'ions mono- ou multichargés selon la revendication 1 dans laquelle la source d'ions (26) est du type à résonance cyclotron électronique.

3. Installation d'implantation d'ions mono- ou multichargés selon l'une des revendications 1 ou 2, comprenant une source de gaz (40) agencée pour délivrer du gaz dans la chambre à vide (20) via une valve d'admission (38) à laquelle la source de gaz (40) est raccordée.

4. Installation d'implantation d'ion mono- ou multichargés selon la revendication 3, dans laquelle le gaz contenu dans la source de gaz (40) est un gaz noble.

5. Installation d'implantation d'ion mono- ou multichargés selon l'une des revendications 1 à 4, dans laquelle le matériau à partir duquel le faisceau d'ions est produit est choisi parmi l'azote N, le carbone C, l'oxygène O, l'argon Ar, l'hélium He et le néon Ne.

6. Installation d'implantation d'ions mono- ou multichargés selon l'une des revendications 1 à 5, dans laquelle la source d'ions est agencée de sorte qu'elle produise une dose d'implantation ionique dans un intervalle compris entre 1*10¹⁴ ions.cm⁻² et 7.5.10¹⁷ ions.cm⁻², et de préférence entre 1*10¹⁶ ions.cm⁻² et 15*10¹⁶ ions.cm⁻², l'installation comprenant une source haute tension agencée pour produire une tension d'accélération des ions comprise entre 7,5 kV et 40 kV.

7. Installation d'implantation d'ions mono- ou multichargés selon l'une des revendications 1 à 6, comprenant des moyens de mise sous vide agencés de sorte que la pression atmosphérique à l'intérieur de la chambre à vide (20) soit comprise entre 10⁴ Pa et 10⁻⁴ Pa, et de préférence entre 10⁻² Pa et 10⁻⁴ Pa.

## Patentansprüche

1. Ionenimplantationsanlage zum Implantieren einfach oder mehrfach geladener Ionen in die Oberfläche eines zu behandelnden Objekts (24), wobei diese Anlage (28) eine Vakuumkammer (20) umfasst, in der das zu behandelnde Objekt (24) angeordnet ist, wobei die Anlage (18) ferner eine Ionenquelle (26) umfasst, die dazu ausgebildet ist, einen Ionenstrahl (30) einfach oder mehrfach geladener Ionen in die Vakuumkammer (20) einzuspeisen, wobei dieser Ionenstrahl (30) auf die Oberfläche des zu behandelnden Objekts (24) gerichtet ist, wobei die genannte Ionenquelle derart angeordnet ist, dass, wenn die Anlage in Betrieb ist, die einfach oder mehrfach geladenen Ionen auf das zu behandelnde Objekt (24) auftreffen, mehr oder weniger tief in die Oberfläche dieses zu behandelnden Objekts (24) eindringen und sich allmählich ansammeln, wodurch eine elektrostatische Potenzialbarriere entsteht, die dazu neigt, die nachfolgend ankommenden Ionen abzubremsen und zurückzustoßen, wobei die Anlage (18) außerdem eine erste Ultraviolettstrahlungsquelle (32) umfasst, die dazu angeordnet ist, gleichzeitig mit der Ionenquelle (26) betrieben zu werden und eine erste Ultraviolettstrahlung (36) zu erzeugen, wobei die genannte erste Ultraviolettstrahlungsquelle so ausgerichtet ist, dass, wenn die Anlage in Betrieb ist, sich die erste Ultraviolettstrahlung (36) in der Vakuumkammer (20) ausbreitet und auf die Oberfläche des zu behandelnden Objekts (24) fällt, und zwar gleichzeitig mit dem Auftreffen des Ionenstrahls (30) auf die Oberfläche desselben zu behandelnden Objekts (24), damit die Photonen der ersten Ultraviolettstrahlung (36) aus den in der Vakuumkammer (20) vorhandenen Atomen und Molekülen Elektronen freisetzen, die von dem positiven Potenzial der Oberfläche des zu behandelnden Objekts (24) angezogen werden und sich mit den an der Oberfläche des zu behandelnden Objekts (24) vorhandenen Ionen rekombinieren, um die elektrostatischen Ladungen zu neutralisieren, wobei die genannte Anlage ferner eine zweite Ultraviolettstrahlungsquelle (42) umfasst, die dazu angeordnet ist, die Oberfläche des zu behandelnden Objekts (24) mit einer zweiten Ultraviolettstrahlung (46) zu beleuchten, wobei die genannte zweite Ultraviolettstrahlungsquelle so ausgerichtet ist, dass, wenn die Anlage in Betrieb ist, sich die zweite Ultraviolettstrahlung (36) in der Vakuumkammer (20) in einer Richtung ausbreitet, die mit der ersten Ultraviolettstrahlung (36) einen Winkel von etwa 90° bildet.

2. Ionenimplantationsanlage nach Anspruch 1, bei der die Ionenquelle (26) eine Elektronenzyklotronresonanz-Ionenquelle ist.

3. Ionenimplantationsanlage nach einem der Ansprüche 1 oder 2, umfassend eine Gasquelle (40), die an ein Einlassventil (38) angeschlossen ist und dazu angeordnet ist, Gas über das Einlassventil (38) in die Vakuumkammer (20) einzuleiten.

4. Ionenimplantationsanlage nach Anspruch 3, bei der das in der Gasquelle (40) enthaltene Gas ein Edelgas ist.

5. Ionenimplantationsanlage nach einem der Ansprüche 1 bis 4, bei der das Material, aus dem der Ionenstrahl erzeugt wird, aus Stickstoff N, Kohlenstoff C, Sauerstoff O, Argon Ar, Helium He und Neon Ne ausgewählt ist.

6. Ionenimplantationsanlage nach einem der Ansprüche 1 bis 5, bei der die Ionenquelle derart angeordnet ist, dass sie eine Ionenimplantationsdosis in einem Bereich zwischen 1*10¹⁴ Ionen·cm⁻² und 7,5,10¹⁷ Ionen·cm⁻², vorzugsweise zwischen 1*10¹⁰ Ionen·cm⁻² und 15*10¹⁶ Ionen·cm⁻², erzeugt, wobei die Anlage ferner eine Hochspannungsquelle umfasst, die dazu angeordnet ist, eine Beschleunigungsspannung der Ionen zwischen 7,5 kV und 40 kV zu erzeugen.

7. Ionenimplantationsanlage nach einem der Ansprüche 1 bis 6, umfassend Evakuierungsmittel, die derart angeordnet sind, dass der Druck im Inneren der Vakuumkammer (20) zwischen 10⁴ Pa und 10⁻⁴ Pa und vorzugsweise zwischen 10⁻² Pa und 10⁻⁴ Pa liegt.

## Claims

1. An installation for implanting monoatomic or polyatomic ions in a surface of an object to be treated (24), this installation (28) comprising a vacuum chamber (20) in which the object to be treated (24) is placed, the installation (18) also comprising a source of ions (26) that injects a beam of monoatomic or polyatomic ions (30) into the vacuum chamber (20), this ion beam (30) being directed towards the surface of the object to be treated (24), the said ion source being arranged so that, when the installation is in operation, the monoatomic or polyatomic ions strike the object to be treated (24) and penetrate more or less deeply into the surface of this object to be treated (24) and gradually accumulate, thus creating an electrostatic potential barrier that tends to slow and repel the ions that subsequently arrive, the installation (18) also comprising a first source of ultraviolet radiation (32) arranged to function at the same time as the ion source (26) and to produce a first ultraviolet radiation (36), the said first source of ultraviolet radiation being oriented so that, when the installation is in operation, the first ultraviolet radiation (36) propagates in the vacuum chamber (20) and falls onto the surface of the object to be treated (24) at the same time as the ion beam (30) strikes the surface of this same object to be treated (24) so that the photons from the first ultraviolet radiation (36) strip the atoms and molecules present in the vacuum chamber (20) of the electrons which will be attracted by the positive potential of the surface of the object to be treated (24) and will recombine with the ions present on the surface of the object to be treated (24), so as to cancel out the electrostatic charges, the said installation further comprising a second source of ultraviolet radiation (42) arranged to illuminate the surface of the object to be treated (24) with a second ultraviolet radiation (46), the said second source of ultraviolet radiation being oriented so that, when the installation is in operation, the second ultraviolet radiation (36) propagates in the vacuum chamber (20) in a direction forming an angle of approximately 90° with the first ultraviolet radiation (36).

2. The installation for implanting monoatomic or polyatomic ions according to claim 1, in which the ion source (26) is of the electron cyclotron resonance type.

3. The installation for implanting monoatomic or polyatomic ions according to any of claims 1 or 2, comprising a source of gas (40) arranged to deliver gas into the vacuum chamber (20) via an inlet valve (38) to which the source of gas (40) is connected.

4. The installation for implanting monoatomic or polyatomic ions according to claim 3, in which the gas contained in the gas source (40) is a noble gas.

5. The installation for implanting monoatomic or polyatomic ions according to any of claims 1 to 4, in which the material from which the ion beam is produced is chosen among nitrogen N, carbon C, oxygen O, argon Ar, helium He and neon Ne.

6. The installation for implanting monoatomic or polyatomic ions according to any of claims 1 to 5, in which the ion source is arranged to produce an ion implantation dose in a range comprised between 1*10¹⁴ ions.cm⁻² and 7.5.10¹⁷ ions.cm⁻², and preferably between 1*10¹⁶ ions.cm⁻² and 15*10¹⁶ ions.cm⁻², the installation comprising a high-voltage source arranged to produce an acceleration voltage of the ions comprised between 7.5 kV and 40 kV.

7. The installation for implanting monoatomic or polyatomic ions according to any of claims 1 to 6, comprising means for generating a vacuum designed such that the atmospheric pressure inside the vacuum chamber (20) is comprised between 10⁴ Pa and 10⁻⁴ Pa and preferably between 10⁻² Pa and 10⁻⁴ Pa.
